# EUROPEAN PATENT SPECIFICATION

(11) **EP 3 503 160 B1**
(45) Date of publication and mention of the grant of the patent: **13.07.2022**
(21) Application number: 17210431.7
(22) Date of filing: 22.12.2017
(51) Int. Cl.: H01J 49/00, B81C 1/00, H01J 49/42

(54) **A METHOD FOR FABRICATION OF AN ION TRAP**
VERFAHREN ZUR HERSTELLUNG EINER IONENFALLE
PROCÉDÉ DE FABRICATION D'UN PIÈGE À IONS

(43) Date of publication of application: 26.06.2019
(73) Proprietor: IMEC vzw, 3001 Leuven (BE)
(72) Inventor: HUYGHEBAERT, Cedric, 3001 Leuven (BE); BEYNE, Eric, 3001 Leuven (BE)
(74) Representative: AWA Sweden AB

(56) References cited:
- US-A1- 2005 189 488
- US-B1- 6 870 158
- US-B1- 7 154 088
- MARCUS D HUGHES ET AL: "Microfabricated Ion Traps", ARXIV.ORG, CORNELL UNIVERSITY LIBRARY, 201 OLIN LIBRARY CORNELL UNIVERSITY ITHACA, NY 14853, 17 January 2011 (2011-01-17), XP080473650, DOI: 10.1080/00107514.2011.601918
- FRISO H W VAN AMEROM ET AL: "MICROFABRICATION OF CYLINDRICAL ION TRAP MASS SPECTROMETER ARRAYS FOR HANDHELD CHEMICAL ANALYZERS", CHEMICAL ENGINEERING COMMUNICATIONS, vol. 195, no. 2, 14 December 2007 (2007-12-14), pages 98-114, XP008168862, ISSN: 0098-6445, DOI: 10.1080/00986440701569176 [retrieved on 2007-12-14]
- TIINA SIKANEN ET AL: "Microchip technology in mass spectrometry", MASS SPECTROMETRY REVIEWS, 9 June 2009 (2009-06-09), pages n/a-n/a, XP055003865, ISSN: 0277-7037, DOI: 10.1002/mas.20238
- BROWNNUTT M ET AL: "Monolithic microfabricated ion trap chip design for scaleable quantum processors", NEW JOURNAL OF PHYSICS, INSTITUTE OF PHYSICS PUBLISHING, BRISTOL, GB, vol. 8, no. 10, 10 October 2006 (2006-10-10), pages 232-232, XP020107548, ISSN: 1367-2630, DOI: 10.1088/1367-2630/8/10/232

## Description

### Technical field

The present inventive concept relates to a method for fabrication of an ion trap.

### Background

Quantum information science has the potential to radically improve existing techniques and devices for sensing, computation, simulation, and communication. Trapped-ion systems have been used in pioneering experiments showcasing quantum information systems of a small to medium size. The experiments are typically performed in dedicated room-sized laboratory setups employing manually assembled and optimized ion trapping systems. Therefore, quantum information processing experiments are still expensive and time consuming endeavors. Existing laboratory setups may also be challenging to fine tune and scale.

The article "Microfabricated Ion Traps" (Marcus D Hughes et al, Arxiv.org, Cornell University Library, 201 Olin Library Cornell University Ithaca, NY 14853) discloses various techniques for fabricating ion traps and the article "MICROFABRICATION OF CYLINDRICAL ION TRAP MASS SPECTROMOTER ARRAYS FOR HANDHELD CHEMICAL ANALYZERS" (Frio H W Van Amerom et al, Chemical Engineering Communications, vol. 195, no. 2) discloses how to form a cylindrical ion trap for mass analysis using wafer bonding techniques.

### Summary

An objective of the present inventive concept is to provide method allowing accurate, repeatable and scalable manufacturing of ion traps. Additional and alternative objectives may be understood from the following.

According to an aspect of the present inventive concept there is provided a method for fabrication of an ion trap according to claim 1. Thereby the ion trap may be defined.

The inventive method enables accurate, repeatable and scalable manufacturing of ion traps by combining the advantages of the processing accuracy allowed by state of the art semiconductor-processing and 3D integration techniques, i.e. wafer-to-wafer bonding.

Forming the electrode structures on separate first and second semiconductor wafers, forming cavity parts in the respective wafers and bonding the wafers to form an aggregate ion cavity from the cavity parts, allows forming of an ion trap with an advantageous degree of control of the positioning of the electrodes in relation to the ion cavity.

In terms of device properties, the method enables fabrication of ion traps, and ion trap systems comprising such ion traps, having improved trapping performance and improved uniformity in terms of structure and performance. Moreover, the method is scalable to allow fabrication of greater capacity ion traps, i.e. trap systems allowing trapping of plural ions.

Although the method may present a general applicability to fabrication of ion traps for various purposes, the method may be especially advantageous for fabrication of an ion trap for a trapped-ion qubit device, such as a trapped-ion quantum computer.

As used herein, the first main surface and the second main surface of a wafer (e.g. of the first wafer or of the second wafer) may also be referred to as the front side surface and backside surface, respectively, of the wafer.

The first cavity part may be formed as a first trench in the second main surface of the first wafer. Correspondingly, the second cavity part may be formed as a second trench in the second main surface of the second wafer. The first trench and the second trench may, upon the bonding of the first and the second wafer, be aligned with each other such that a common longitudinal cavity is defined by the first trench and the second trench, the cavity trench being enclosed by the first and the second wafer.

The bonding of the first wafer to the second wafer may include forming a stack of the first wafer, the second wafer and a bonding layer intermediate the first wafer and the second wafer. Various advantageous embodiments related to wafer bonding are provided below.

The method comprises:
performing a first damascene process to form the first electrode structure and an insulating layer on the first main surface of the first semiconductor wafer, the first electrode structure being embedded in the insulating layer formed on the first main surface of the first semiconductor wafer, and
performing a second damascene process to form the second electrode structure and an insulating layer on the first main surface of the second semiconductor wafer, the second electrode structure being embedded in the insulating layer formed on the first main surface of the second semiconductor wafer.

The electrode structures are accordingly formed using damascene processing. Damascene processing (such as single damascene processing, dual damascene processing, or a combination of single and dual damascene processing) allows forming of electrode structures in one or more levels or above a wafer main surface. State of the art lithography and etching techniques such as single patterning techniques (e.g. litho-etch - "LE"), or even multiple patterning techniques (e.g. LE^{x}), may be employed for forming the electrode structures with a high degree of control in an efficient and rational manner. Additionally, damascene processing allows forming of electrode structures with comparably smooth surfaces and line edges, which may provide a favorable impact on the trapping performance of the ion trap.

According to one embodiment, the first electrode structure is formed to include a first pair of electrodes and the second electrode structure is formed to include a second pair of electrodes. The first pair or electrodes and the second pair of electrodes may accordingly together define a quadrupole electrode configuration along the ion cavity. An electrodynamic ion trap of a type known as the Paul trap may thus be formed.

Each electrode of the first pair of electrodes may include a respective lower electrode portion formed in a lower portion of the insulating layer (formed on the first wafer), a respective upper electrode portion formed in an upper portion of the insulating layer, and a respective electrode via portion extending through the insulating layer and interconnecting said respective lower and upper electrode portions, and wherein said respective lower and upper electrode portions protrudes from said respective electrode via portion, in a plane extending along the first main surface of the first wafer. Each electrode may thereby be provided with an ion cavity facing portion (i.e. the lower portion) a contact portion (i.e. the upper portion) and a vertical interconnecting portion (i.e. the electrode via portion) interconnecting the contact portion and the ion cavity facing portion. As the respective upper and lower portions are formed to protrude from the electrode via portion, each electrode may "grip" about a portion of the insulating layer, thereby improving the structural stability of the electrode and the portion of the insulating layer aligned with the cavity parts.

The first pair of electrodes may be formed in a (first) damascene process including:
depositing a first insulating partial-layer on the first wafer,
patterning, in the first partial-layer, recesses for the lower electrode portions, and depositing a conductive material in the recesses to form the lower electrode portions,
depositing a second insulating partial-layer on the first partial-layer,
patterning, in the second partial layer, holes for the electrode via portions and recesses for the upper electrode portions, and depositing a conductive material in the holes and recesses in the second partial-layer to form the electrode via portions and the upper electrode portions.

The first partial-layer and the second partial-layer may together form the insulating layer embedding the first pair of electrodes.

Correspondingly, each electrode of the second pair of electrodes may include a respective lower electrode portion formed in a lower portion of the insulating layer, a respective upper electrode portion formed in an upper portion of the insulating layer (formed on the second wafer), and a respective electrode via portion extending through the insulating layer and interconnecting said respective lower and upper electrode portions, and wherein said respective lower and upper electrode portions protrudes from said respective electrode via portion, in a plane extending along the first main surface of the second wafer.

The second pair of electrodes may be formed in a (second ) damascene process including:
depositing a first insulating partial-layer on the second wafer,
patterning, in the first partial-layer, recesses for the lower electrode portions, and depositing a conductive material in the recesses to form the lower electrode portions,
depositing a second insulating partial-layer on the first partial-layer, patterning, in the second partial layer, holes for the electrode via portions and recesses for the upper electrode portions, and depositing a conductive material in the holes and recesses in the second partial-layer to form the electrode via portions and the upper electrode portions.

The first partial-layer and the second partial-layer may together form the insulating layer embedding the second pair of electrodes.

According to one embodiment the first cavity part is formed by etching the first semiconductor wafer from the second main surface thereof, and the second cavity part is formed by etching the second semiconductor wafer from the second main surface thereof. The first cavity part and the second cavity part may accordingly be formed by etching from a backside of the first wafer and the second wafer, respectively. Etching allows the cavity parts to be formed with an advantageous degree of process control. For instance, the lateral dimensions of the cavity parts may be controlled through etch mask patterning. A vertical dimension (i.e. the "depth" of the respective cavity part) may be controlled via the etching process duration and a rate of etching. Moreover, by etching the cavity parts from the backside of the wafers, exposure of the electrode structures to the etchants may be limited.

A first etch stop layer may be formed between the first main surface of the first wafer and the first electrode structure. The etching of the first semiconductor wafer may be continued until the first etch stop layer is exposed. The etching may be stopped on the first etch stop layer. Thereby the first electrode structure may be protected from the etchants used for forming the first cavity part. Subsequently, the first etch stop layer may be removed in a further etch step, wherein the first electrode structure is exposed in the first cavity part. Likewise, a second etch stop layer may be formed between the first main surface of the second wafer and the second electrode structure. The etching of the second semiconductor wafer may be continued until the second etch stop layer is exposed. The etching may be stopped on the second etch stop layer. Thereby the second electrode structure may be protected from the etchants used for forming the second cavity part. Subsequently, the second etch stop layer may be removed in a further etch step, wherein the first electrode structure is exposed in the second cavity part. First and second cavity part may thus be formed to extend completely through of the first wafer and the second wafer, respectively.

According to one embodiment, the method further comprises, prior to forming the first cavity part, forming a bonding layer on the second main surface of the first semiconductor wafer. Alternatively or additionally, a bonding layer may be formed on the second main surface of the second semiconductor wafer. Forming a bonding layer prior to forming a cavity part simplifies the subsequent process. Had a bonding layer instead been formed subsequent to forming the cavity part, masking of the cavity part during forming of the bonding layer could be needed as well as subsequent removal of mask material from inside of the cavity part. Alternatively, if not masked, removal of bonding layer portions from inside of the cavity part could be needed. Any of these processes could adversely affect the surface properties of the bonding layer outside of the cavity part.

According to one embodiment, the method further comprises, prior to forming the first cavity part, forming a bonding layer on the second main surface of the first semiconductor wafer, and prior to forming the second cavity part, forming a bonding layer on the second main surface of the second semiconductor wafer. Forming a bonding layer on each of the first wafer and the second wafer may improve a quality of the bonding.

Each of the bonding layers may be a dielectric layer wherein said bonding may include arranging the first semiconductor wafer with respect to the second semiconductor wafer such that the bonding layer on the first semiconductor wafer abuts the bonding layer on the second semiconductor wafer. This enables the first wafer and the second wafer to be bonded by direct-bonding, which may yield a strong bonding through comparatively thin bonding layers.

According to one embodiment the method further comprises, subsequent to forming the first electrode structure and prior to forming the first cavity part, thinning of the first semiconductor wafer. Alternatively, or additionally, subsequent to forming the second electrode structure and prior to bonding together the first and the second wafer, thinning of the second wafer may be performed. This allows a first and/or second wafer of a thickness greater than desired in a finally bonded structure (in view of a desired vertical dimension/height of the final ion cavity) to be used as starting structure(s) for the method. For instance, commercially available semiconductor wafers may have thicknesses rendering them initially unsuitable for the present method.

The method may further comprise: subsequent to forming the first electrode structure and prior to forming the first cavity part, bonding the first semiconductor wafer to a first carrier wafer with the first main surface of the first semiconductor wafer facing the carrier wafer. Additionally, or alternatively, the method may further comprise: subsequent to forming the second electrode structure and prior to forming the second cavity part, bonding the second semiconductor wafer to a second carrier wafer with the first main surface of the second semiconductor wafer facing the second carrier wafer. A carrier wafer may facilitate handling of the first and/or second wafers during process steps such as forming of the cavity parts, the bonding of the first and second semiconductor wafers, and during optional wafer thinning.

The method may further comprise, subsequent to the bonding together of the first wafer and the second wafer, removing at least one of the first carrier wafer and the second carrier wafer.

According to one embodiment, the first electrode structure is embedded in an insulating layer formed on the first semiconductor wafer, and the method further comprises forming a through-hole in the insulating layer by etching, wherein (subsequent to the wafer bonding) said through-hole forms a light aperture of the ion cavity. The light aperture allows light from a light source, for instance a laser, to enter the ion cavity to interact with ions trapped therein.

Also the second electrode structure may be embedded in an insulating layer formed on the second semiconductor wafer, and the method may further comprise forming a through-hole in the insulating layer by etching, wherein (subsequent to the wafer bonding) said through-holes form a light inlet aperture of the ion cavity and a light outlet aperture of the ion cavity, respectively.

The first electrode structure and the second electrode structure may as described above be formed to include a first pair of electrodes and a second pair of electrodes, respectively, wherein the method may comprise: forming said through-hole in the insulating layer formed on the first semiconductor wafer at a position between the electrodes of the first pair, and forming said through-hole in the insulating layer formed on the second semiconductor wafer at a position between the electrodes of the second pair.

The method may further comprise:
forming, on the first main surface of the first semiconductor wafer, a third electrode structure, and
forming, on the first main surface of the second semiconductor wafer, a fourth electrode structure,
wherein the first cavity part is formed as a first trench in the second main surface of the first wafer, wherein the first electrode structure and the third electrode structure are arranged along the first trench,
wherein the second cavity part is formed as a second trench in the second main surface of the second wafer, wherein the second electrode structure and the fourth electrode structure are arranged along the second trench, and
wherein the first trench and the second trench, upon the bonding of the first semiconductor wafer and the second semiconductor wafer, are aligned with each other such that a common longitudinal cavity is defined by the first trench and the second trench.

Thereby a longitudinal ion trap cavity, enclosed by the first semiconductor wafer and the second semiconductor wafer, may be formed with electrode pairs disposed along the cavity. The first and the second electrode structures may together define a first quadrupole electrode. The third and the fourth electrode structures may together define a second quadrupole electrode.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1A-J schematically illustrate a method for fabrication of an ion trap.
Fig. 2A-B schematically illustrate a bottom and top view of a set of ion traps.

### Detailed description

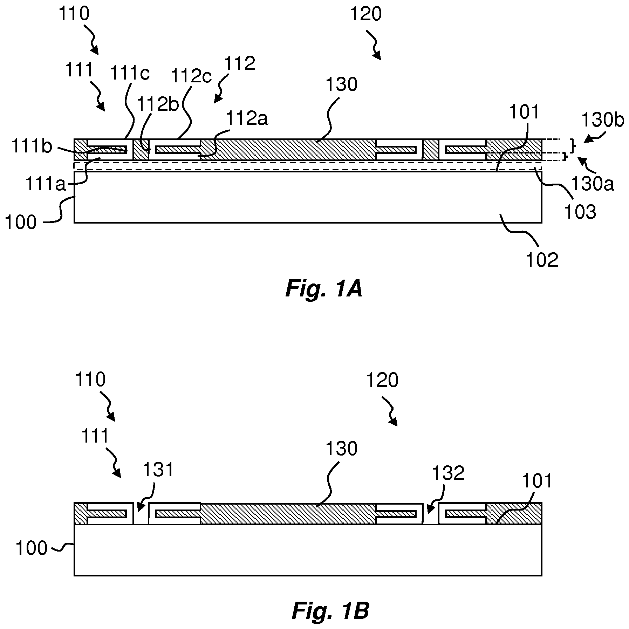

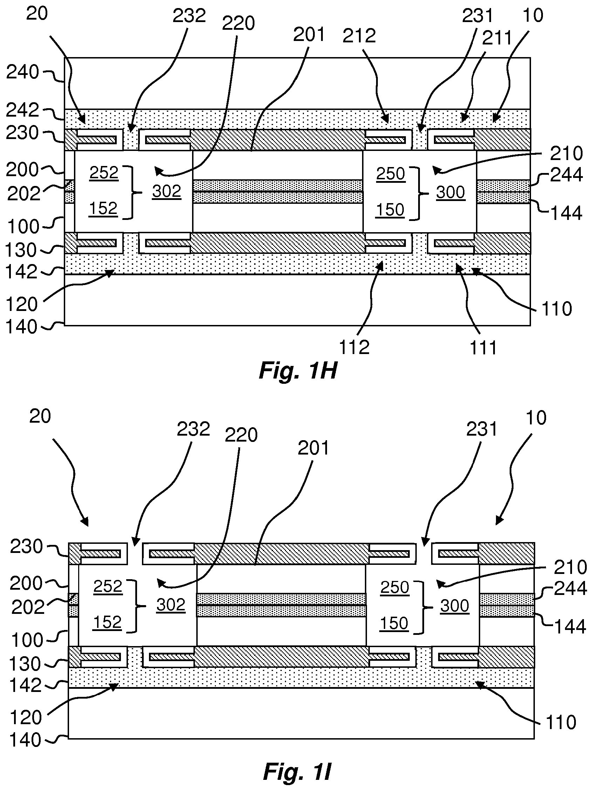

A method for fabrication of an ion trap will now be disclosed in connection with figures 1A-J. Each one of the figures shows a cross-sectional side view of one or more wafers. Although in the following, forming of two ion traps will be described and illustrated it should be noted that a plurality of such ion traps may be formed in parallel, or only a single ion trap may be formed. Moreover, the wafers may present an in-plane extension, i.e. horizontal extension, exceeding the extension shown in the figures. It should further be noted that the relative dimensions of the shown elements, in particular the relative thickness of the layers, is merely schematic and may, for the purpose of illustrational clarity, differ from a physical structure.

Figure 1A shows a first semiconductor wafer 100, hereinafter referred to as wafer 100. The wafer 100 may consist of a semiconductor material or at least include a layer of semiconductor material. The wafer 100 may for instance be a silicon (Si) substrate, a silicon-on-insulator (SOI), a germanium (Ge) substrate, a silicon-germanium (SiGe) substrate, a silicon-carbide (SiC) substrate, a Ge on insulator (GeOI) substrate or a SiGeOI substrate to name a few examples. The wafer 100 has a first main surface 101 and an oppositely disposed second main surface 102. The surface 101 may be referred to as a front side surface. The surface 102 may be referred to as a backside surface.

A first electrode structure 110 has been formed on the wafer 100, at the side of the first surface 101, i.e. on the front side of the wafer 100. An additional first electrode structure 120, similarly configured as the first electrode structure 110, has also been formed on the first surface 101. The electrode structures 110, 120 are embedded in an insulating layer 130. The insulating layer 130 may be for instance a dielectric material layer including one or more layers of dielectric material, for instance one or more oxide layers such as silicon oxide layers.

The first electrode structure 110 (and correspondingly the electrode structure 120) includes a first pair of electrodes 111, 112. The electrode 111 and the electrode 112 are spaced apart from each other. A separation between the electrode 111 and the electrode 112 may by way of example be in the range of 50-200 µm. The electrodes 111, 112 each include a respective lower electrode portion 111a, 112a. The lower electrode portions 111a, 112a may form ion cavity facing electrode portions (i.e. at a later stage when the ion cavity has been formed). The electrodes 111, 112 each further include a respective upper electrode portion 111c, 112c. The upper electrode portions 111c, 112c may form contact portions (e.g. for electrode driving circuitry of the ion trap to be formed). The lower electrode portions 111a, 112a are connected to the respective upper electrode portions 111c, 112c through respective electrode via portions 111b, 112b. As shown in figure 1a, the respective lower and upper electrode portions 111a, 111c and 112b, 112c of the electrode 111 and the electrode 112, respectively, protrude from the respective electrode via portions 111b, 112b, in a plane extending along the surface 101 of the wafer 100.

More specifically, the lower electrode portion 111a and the upper electrode portion 111c each protrude from the via portion 111b, in a first direction parallel to the surface 101 of the wafer 100. Correspondingly, the lower electrode portion 112a and the upper electrode portion 112c protrude from the via portion 112b, in a second direction opposite to the first direction and parallel to the surface 101 of the wafer 100. Thus, the lower electrode portions 111a, 111c and the upper electrode portions 112a, 112c, respectively grip about a respective thickness portion of the insulating layer 130.

In the drawings the lower and upper electrode portions 111a, 111c and 112a, 112c are shown to be of similar thickness and lateral dimensions. However it is also possible, in some instances even preferable, to form the upper electrode portions 111c, 112c with greater lateral dimensions and/or greater thickness than the corresponding lower electrode portions 111c, 112c to facilitate contacting with surrounding circuitry.

The electrode structures 110, 120 have been formed in a damascene process. With reference to the electrode structure 110, forming the pair of electrodes 111, 112 in a damascene process may include depositing a first insulating partial-layer 130a on the surface 101 of the wafer 100, patterning recesses in the first partial-layer 130a and depositing a conductive material (e.g. Cu, Al, Au, Ag or other metal to name a few non-limiting examples) covering the first partial-layer 130a and filling the recesses. Overburden conductive material (if present) may be removed by chemical-mechanical-polishing (CMP) and/or etch back to form the lower electrode portions 111a, 112a in the recesses. The electrode via portions 111b, 112b and the upper electrode portions 111c, 112c may be subsequently formed by depositing a second partial layer 130b on the first partial layer 130a and patterning via holes and recesses in the second partial-layer. By conductive material deposition and overburden conductive material removal (if overburden conductive material is present), the electrode via portions 111b, 112b and the upper electrode portions 111c, 112c may subsequently be formed in the recesses and via holes in the second partial layer 130b.

It should however be noted that electrode structures of other configurations than shown also are possible and/or may be formed using other processes. For instance, an electrode structure may be formed by a pair of electrode layers including only a single level of conductive material. A conductive layer material may be deposited and subsequently patterned into a pair of separate electrodes. An insulating layer may thereafter be deposited to embed the pair of electrodes.

Optionally, an etch stop layer 103 may be formed on the first main surface 101 of the wafer 100 wherein the electrode structures 110, 120 may be formed on the etch stop layer 103. The etch stop layer 103 may for instance be of a dielectric material such as a silicon oxide layer or a silicon nitride layer. As will be further described below an etch stop layer 103 may protect the electrode structures 110, 120 from etchants used during forming of cavity parts through the wafer 100. The etch stop layer 103 has for illustrational clarity been omitted from the further figures.

In figure 1B, a through-hole 131 has been formed in the insulating layer 130 at a position between the electrodes 111, 112. The through-hole 131 extends through the insulating layer 130 to expose the surface 101 of the wafer 100 (or etch stop layer 103 if present). As will be further described below, the through-hole 131 may form a light aperture of the ion cavity to be formed. A mask layer (e.g. any typical lithographic stack compatible with the insulating layer material and electrode material) may be deposited on the insulating layer 130. An opening may be patterned in the mask layer. The opening may subsequently be transferred into the insulating layer 130 by etching the insulating layer 130 at a position between the electrodes 111, 112. Any conventional dry or wet etch process may be used which allows the insulating layer material (e.g. silicon oxide) to be selectively etched from the electrode material (e.g. metal). The mask layer may thereafter be removed. As shown, a corresponding through-hole 132 may be formed between the pair of electrodes of the electrode structure 120, for instance during a same litho-etch process as the first through-hole 131.

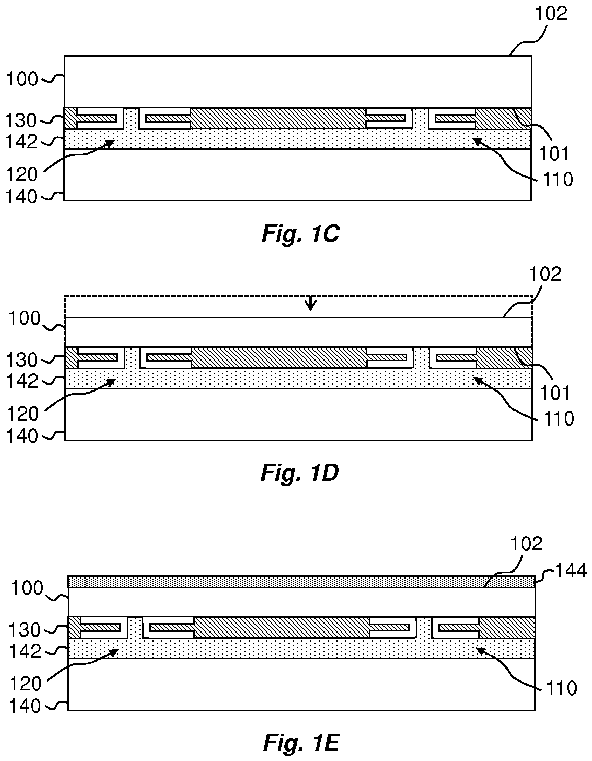

In figure 1C, the first semiconductor wafer 100 (with the electrode structures 110, 120 and insulating layer 130 formed thereon) has been transferred to, and bonded to, a first carrier wafer 140 with the surface 101 facing the carrier wafer 140. A bonding layer 142, for instance of a thermal bonding material (TBM), has been coated on the carrier wafer 140 and/or the wafer 100 to enable the bonding.

In figure 1D, a thinning of the wafer 100 has been performed. A thickness reduction of the first wafer 100 may be achieved by CMP and/or etch back of the wafer 100 from the surface 102 until a desired reduced thickness has been obtained. During the thinning the carrier wafer 140 may support the wafer 100. It should however be noted that the thinning of the wafer 100 is optional and may be omitted, provided the wafer 100 already presents a suitable thickness.

In figure 1E, a bonding layer 144 has been formed on the surface 102 of the (thinned) wafer 100. For instance, a silicon oxide, a silicon nitride or a silicon-carbon-oxide layer may be deposited on the surface 102 by any conventional deposition technique, such as chemical vapor deposition (CVD) or by atomic layer deposition (ALD).

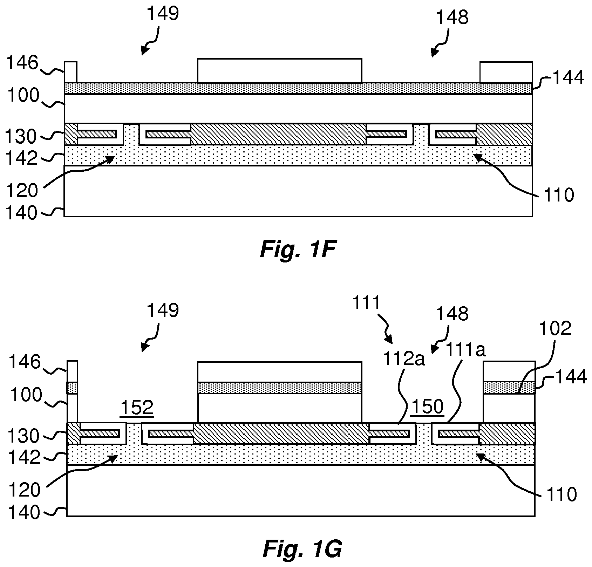

Figures 1F, G illustrate forming of a first cavity parts 150, 152 extending through the wafer 100:
In figure 1F, a mask layer 146 has been formed on the bonding layer 144. The mask layer may be photo-resist layer or any other typical lithographic stack compatible with the materials of the bonding layer 144 and the wafer 100. An opening 148 may be patterned in the mask layer 146 in a lithographic process. As may be seen in figure 1F, the opening is formed directly above the electrode structure 110, i.e. to overlap the electrode structure 110. The lateral dimension of the opening may correspond to the desired lateral/width dimension of the ion cavity to be formed. Preferably, the lateral dimension of the opening is such that the substrate semiconductor material may be removed from an entire respective cavity facing surface of the electrode portions 111a, 112b. A corresponding opening 149 may be formed directly above the electrode structure 120.

In figure 1G, the opening 148 in the mask layer 146 has been transferred into the wafer 100 by etching through the opening 148 to form the first cavity part 150. The etching may include a dry etching process, such as a reactive ion etch (RIE), or a combination of a wet etching process and a dry etching process. The etching process may be biased to etching (substantially) only in thickness direction of the wafer 100.

The etching through the wafer 100 may be continued until the lower electrode portions 111a, 112a become exposed. In response to the first electrode structure being exposed, the etching of the first cavity part 150 may be stopped. Optionally, the etching process may be stopped just prior to the electrode portions 111a, 112 being exposed to leave a relatively thin layer of wafer material thereon. According to a further option, if the etch stop layer 103 is present between the main surface 101 of the wafer 100 and the electrode structures 110, 120 (as shown in figure 1a), the etching of the wafer 100 may be continued until the etch stop layer 103 is exposed. Subsequently, the etch stop layer 103 may be removed in a further etch step, such as a comparably short dielectric wet etch step, wherein the electrode structures 110, 120 become exposed in the first cavity part 150. In any case the cavity part 150 may be formed to extend from the surface 102, through the wafer 100 towards the electrode structure 110. Following completion of the etching, the mask layer 146 may be removed. The further cavity part 152 may be formed in a corresponding manner by etching through the opening 149.

As may be seen in figure 1G, the lateral dimension or width of the cavity parts 150, 152 may be formed such that the entire cavity facing surface of the electrode portions 111a, 112a are exposed in the cavity. Hence, no semiconductor material remains on the cavity facing surfaces of the electrode portions 111a, 112a.

Figure 1H shows in addition to the first wafer 100, a second semiconductor wafer 200. The second wafer 200 may have been processed in a same manner as the first wafer 100 to include features corresponding to those of the first wafer 100. Accordingly, a second electrode structure 210 including a second pair of electrodes 211, 212 is formed on a first main surface 201 of the wafer 200 (for instance formed in a damascene process as disclosed above in connection with the first electrode structure 110). The electrode structure 210 is embedded in an insulating layer 230. Additionally, a further second electrode structure 220 has been formed on the first main surface 201. A second cavity part 250 extends through the wafer 200 from a second main surface 202 thereof towards the second electrode structure 210. A further second cavity part 252 extends through the wafer 200 from a second main surface 202 thereof towards the further second electrode structure 220.

Through-holes 231, 232 has been formed in the insulating layer 230 at positions between the pairs of electrodes of the respective electrode structures 210, 220. The wafer 200 is bonded to a second carrier wafer 240 by beans of a bonding layer 242 of for instance TBM. A bonding layer 244, for instance of a same material as the bonding layer 114, is formed on the surface 202.

In figure 1H, the second wafer 200 has been transferred to the first semiconductor wafer 100, or vice versa. The first wafer 100 is arranged with respect to the second wafer 200 such that the bonding layer 144 on the first wafer 100 abuts the bonding layer 244 on the second wafer 200 wherein the first wafer 100 and the second wafer 200 have been bonded together. Optionally, the bonding of the wafers 100, 200 may triggered by subjecting the stacked wafers 100, 200 to an annealing process.

More specifically, the first wafer 100 and the second wafer 200 are positioned in relation to each other such that the first cavity part 150 and the second cavity part 250 become aligned to together define an ion cavity 300 of an ion trap 10. The first electrode structure 110 and the second electrode structure 210 accordingly become arranged on opposite sides of the ion cavity 300. As may be seen in figure 1H, a separation between the electrode structures 210, 220 matches a separation between the electrode structures 110, 120. Correspondingly, a separation between the first cavity parts 150, 152 matches a separation between the second cavity parts 250, 252. Accordingly, the further first cavity part 152 and the further second cavity part 252 become aligned to together define a further ion cavity 302 of an ion trap 20.

In figure 11, the second carrier wafer 240 has been removed from the second wafer 200. Moreover, the bonding layer 242 has been removed. A TBM bonding layer may for instance be removed by a debonding process inducing cracks in the bonding layer 242, for instance by application of vibrations of exposing the bonding layer 242 to laser light. Alternatively or additionally, a bonding layer 242 of TBM may be removed using a suitable solvent.

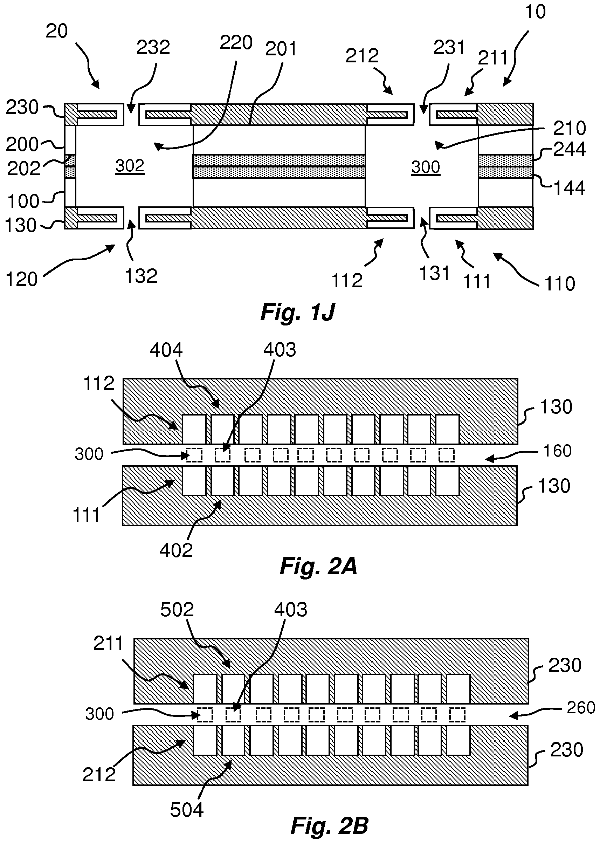

As shown in figure 1J, also the first carrier wafer 140 (and the bonding layer) may be removed from the first wafer 100. Figure 1J accordingly shows the ion trap 10 comprising the ion cavity 300 and electrode structures 110, 210.

The structure of figure 1J may be incorporated into an ion trapping platform including further state of the art elements such as laser light sources, light detecting system and circuitry for supplying voltages to the electrodes. By applying appropriate voltages to the electrodes, in a manner which per se is known in the skilled art, the electrodes 111, 112, 212, 231 may together operate in a quadrupole configuration to generate an electrical field in the ion cavity 300, i.e. a Paul trap. The electrical field may be used to trap a single ion in the ion cavity 300 for trapping. A further pair of electrodes may be disposed to provide ion confinement along the trapping axis (i.e. into the viewing plane of figure 1J). Light inlet and light outlet apertures 131, 231 leading into the ion cavity 300 extend between the respective electrode pairs of the electrode structures 110, 210. A laser light source may be arranged to emit light into the ion cavity 300, via the light inlet aperture 131, for interacting with a trapped ion, thereby implementing manipulation of a qubit. A state of the trapped qubit ion may be detected by a light detecting system (including e.g. spectrometers and photo detectors). Similarly, the ion trap 20 comprises the ion cavity 302 and electrode structures 120, 220. Light inlet and light outlet apertures 132, 232 leading into the ion cavity 302 extend between the respective electrode pairs of the electrode structures 120, 220. The manner of operating a structure as shown in figure 1J for ion trapping purposes is per se known in the art and will therefore not be further described herein.

In the above, forming of one ion trap in an ion cavity 300 has been disclosed. However, it is also possible to form two or more ion traps along a same cavity. In figure 2A there is shown a variation of the structure shown in figure 1J, in a plane view from the side of the insulating layer 130. Figure 2B shows a corresponding plane view however from the side of the insulating layer 230. The part of the structure including the ion cavity 300 is shown while the part including the ion cavity 302 has been omitted. In the following reference will be made to figures 2A, 2B in conjunction with figure 1 J.

The structure shown has been formed to include, in addition to the electrode structure 110 including the electrodes 111, 112, a third electrode structure including a first electrode 402 and a second electrode 404. The third electrode structure 402, 404 may be formed in a same process as the first electrode structure 110, e.g. on the first wafer 100 using a damascene process as disclosed above in connection with figure 1A.

In addition to the electrode structure 210 including the electrodes 211, 212, a fourth electrode structure including a first electrode 502 and a second electrode 504 has been formed. The fourth electrode structure 502, 504 may be formed in a same process as the second electrode structure 210, e.g. on the second wafer 200 using a damascene process as disclosed above in connection with figure 1H and 1A.

Moreover, the first cavity part 150 has been formed as a first trench 160 in the second main surface 102 of the first wafer 100, wherein the first electrode structure 110 and the third electrode structure 402, 404 are arranged along the first trench 160, at different positions along the length of the trench 160. The trench 160 may be obtained by etching through appropriately patterned openings 148, 149 in the mask 146, as disclosed in connection with figures 1F, 1G. The second cavity part 250 has in a similar manner been formed as a second trench 260 in the second main surface 202 of the second wafer 200, wherein the second electrode structure 210 and the fourth electrode structure 502, 504 are arranged along the second trench 260, at different positions along the length of the trench 260.

The first trench 160 and the second trench 260, may subsequently upon the bonding of the first semiconductor wafer 100 and the second semiconductor wafer 200 be aligned with each other such that a common longitudinal cavity is defined by the first trench 160 and the second trench 260. An ion trap may be trapped in the space 300 of the common longitudinal cavity, at a position between the electrodes 111, 112, 211, 212. A further ion trap may be trapped in the space 403 of the common longitudinal cavity, at a position between the electrodes 402, 404, 502, 504. As shown in figure 2A and 2B a set of plural electrode structures may be formed along the common longitudinal cavity for trapping of further ions.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for fabrication of an ion trap (10), the method comprising:
performing a first damascene process to form a first electrode structure (110) and an insulating layer (130) on a first main surface (101) of a first semiconductor wafer (100), the first electrode structure (110) being embedded in the insulating layer (130),
performing a second damascene process to form a second electrode structure (210) and an insulating layer (230) on a first main surface (201) of a second semiconductor wafer (200), the second electrode structure (210) being embedded in the insulating layer (230), and then
forming a first cavity part (150) extending through the first semiconductor wafer (100) from a second main surface (102) thereof towards the first electrode structure (110),
forming a second cavity part (250) extending through the second semiconductor wafer (200) from a second main surface (202) thereof towards the second electrode structure (210), and
bonding together the first semiconductor wafer (100) and the second semiconductor wafer (200) with the second main surface (102) of the first semiconductor wafer (100) facing the second main surface (202) of the second semiconductor wafer (200) and with the first cavity part (150) and the second cavity part (250) being aligned to together define an ion cavity (300), wherein the first electrode structure (110) and the second electrode structure (210) are arranged on opposite sides of the ion cavity (300).

2. A method according to claim 1, wherein the first electrode structure (110) is formed to include a first pair of electrodes (111, 112) and the second electrode structure (210) is formed to include a second pair of electrodes (211, 212).

3. A method according to any of the preceding claims, wherein each electrode of the first pair of electrodes (111, 112) includes a respective lower electrode portion (111a, 112a) formed in a lower portion of the insulating layer (130), a respective upper electrode portion (111c, 112c) formed in an upper portion of the insulating layer (130), and a respective electrode via portion (111b, 112b) extending through the insulating layer (130) and interconnecting said respective lower and upper electrode portions (111a, 111c, 112a, 112c), and wherein said respective lower and upper electrode portions (111a, 111c), 112a, 112c) protrudes from said respective electrode via portion (111b, 112b), in a plane extending along the first main surface (101) of the first wafer (100).

4. A method according to any of the preceding claims,
wherein the first cavity part (150) is formed by etching the first semiconductor wafer (100) from the second main surface (102) thereof, and
wherein the second cavity part (250) is formed by etching the second semiconductor wafer (200) from the second main surface (202) thereof.

5. A method according to any of the preceding claims, further comprising, prior to forming the first cavity part (150), forming a bonding layer (144) on the second main surface (102) of the first semiconductor wafer (100).

6. A method according to claim 5, further comprising, prior to forming the second cavity part (250), forming a bonding layer (244) on the second main surface (202) of the second semiconductor wafer (200).

7. A method according to claim 6, wherein each of said bonding layers (144, 244) is a dielectric layer and wherein said bonding includes arranging the first semiconductor wafer (100) with respect to the second semiconductor wafer (200) such that the bonding layer (144) on the first semiconductor wafer (100) abuts the bonding layer (244) on the second semiconductor wafer (200).

8. A method according to any of the preceding claims, further comprising, subsequent to forming the first electrode structure (110) and prior to forming the first cavity part (150), thinning of the first semiconductor wafer (100).

9. A method according to any of the preceding claims, further comprising:
subsequent to forming the first electrode structure (110) and prior to forming the first cavity part (150), bonding the first semiconductor wafer (100) to a first carrier wafer (140) with the first main surface (101) of the first semiconductor wafer (100) facing the carrier wafer (140), and
subsequent to forming the second electrode structure (210) and prior to forming the second cavity part (250), bonding the second semiconductor wafer (200) to a second carrier wafer (240) with the first main surface (201) of the second semiconductor wafer (200) facing the second carrier wafer (240).

10. A method according to claim 9, further comprising, subsequent to said bonding together of the first semiconductor wafer (100) and the second semiconductor wafer (200), removing at least one of the first carrier wafer (140) and the second carrier wafer (240).

11. A method according to any of the preceding claims, the method further comprises forming a through-hole (131) in the insulating layer (130) by etching, wherein said through-hole (131) forms a light aperture of the ion cavity (300).

12. A method according to claim 11, wherein the method further comprises forming a through-hole (231) in the insulating layer (230) by etching, wherein said through-holes (131, 231) form a light inlet aperture of the ion cavity (300) and a light outlet aperture of the ion cavity (300), respectively.

13. A method according to any of claims 11-12, wherein the first electrode structure (110) is formed to include a first pair of electrodes (111, 112) and the second electrode structure is formed to include a second pair of electrodes (211, 212), and the method comprises: forming said through-hole (131) in the insulating layer (130) formed on the first semiconductor wafer (100) at a position between the electrodes of the first pair (111, 112), and forming said through-hole (231) in the insulating layer (230) formed on the second semiconductor wafer (200) at a position between the electrodes of the second pair (211, 212).

14. A method according to any of the preceding claims, further comprising:
forming, on the first main surface (101) of the first semiconductor wafer (100), a third electrode structure (402, 404), and
forming, on the first main surface (201) of the second semiconductor wafer (200), a fourth electrode structure (502, 504),
wherein the first cavity part (150) is formed as a first trench (160) in the second main surface (102) of the first wafer (100), wherein the first electrode structure (110) and the third electrode structure (402, 404) are arranged along the first trench (160),
wherein the second cavity part (250) is formed as a second trench (260) in the second main surface (202) of the second wafer (200), wherein the second electrode structure (210) and the fourth electrode structure (502, 504) are arranged along the second trench (260), and
wherein the first trench (160) and the second trench (260), upon the bonding of the first semiconductor wafer (100) and the second semiconductor wafer (200), are aligned with each other such that a common longitudinal cavity is defined by the first trench (160) and the second trench (260).

## Patentansprüche

1. Verfahren zur Herstellung einer Ionenfalle (10), wobei das Verfahren umfasst:
Ausführen eines ersten Damascene-Prozesses, um eine erste Elektrodenstruktur (110) und eine Isolierschicht (130) auf einer ersten Hauptfläche (101) eines ersten Halbleiter-Wafers (100) zu bilden, wobei die erste Elektrodenstruktur (110) in die Isolierschicht (130) eingebettet ist,
Ausführen eines zweiten Damascene-Prozesses, um eine zweite Elektrodenstruktur (210) und eine Isolierschicht (230) auf einer ersten Hauptfläche (201) eines zweiten Halbleiter-Wafers (200) zu bilden, wobei die zweite Elektrodenstruktur (210) in der Isolierschicht (230) eingebettet ist, und dann
Bilden eines ersten Kavitätsteils (150), der sich durch den ersten Halbleiter-Wafer (100) hindurch von einer zweite Hauptfläche (102) desselben in Richtung auf die erste Elektrodenstruktur (110) erstreckt,
Bilden eines zweiten Kavitätsteils (250), der sich durch den zweiten Halbleiter-Wafer (200) hindurch von einer zweiten Hauptfläche (202) desselben in Richtung auf die zweite Elektrodenstruktur (210) erstreckt, und
Zusammenbonden des ersten Halbleiter-Wafers (100) und des zweiten Halbleiter-Wafers (200), wobei die zweite Hauptfläche (102) des ersten Halbleiter-Wafers (100) der zweiten Hauptfläche (202) des zweiten Halbleiter-Wafers (200) gegenübersteht, und wobei der erste Kavitätsteil (150) und der zweiten Kavitätsteil (250) aufeinander ausgerichtet sind, um eine lonenkavität (300) zu definieren, in der die erste Elektrodenstruktur (110) und die zweite Elektrodenstruktur (210) auf gegenüberliegenden Seiten der lonenkavität (300) angeordnet sind.

2. Verfahren nach Anspruch 1, wobei die erste Elektrodenstruktur (110) gebildet ist, um ein erstes Elektrodenpaar (111, 112) zu umfassen, und die zweite Elektrodenstruktur (210) gebildet ist, um ein zweites Elektrodenpaar (211, 212) zu umfassen.

3. Verfahren nach einem der vorhergehenden Ansprüche, wobei jede Elektrode des ersten Elektrodenpaars (111, 112) einen jeweiligen unteren Elektrodenabschnitt (111a, 112a), der in einem unteren Abschnitt der Isolierschicht (130) gebildet ist, einen jeweiligen oberen Elektrodenabschnitt (111c, 112c), der in einem oberen Abschnitt der Isolierschicht (130) gebildet ist, und einen jeweiligen Elektrodendurchkontaktierungsabschnitt (111b, 112b), der sich durch die Isolierschicht (130) hindurch erstreckt und die jeweiligen unteren und oberen Elektrodenabschnitte (111a, 111c, 112a, 112c) zusammenschaltet, umfasst, und
wobei die jeweiligen unteren und oberen Elektrodenabschnitte (111a, 111c, 112a, 112c) aus dem jeweiligen Elektrodendurchkontaktierungsabschnitt (111b, 112b) in einer Ebene, die sich entlang der ersten Hauptfläche (101) des ersten Wafers (100) erstreckt, überstehen.

4. Verfahren nach einem der vorhergehenden Ansprüche,
wobei der erste Kavitätsteil (150) durch Ätzen des ersten Halbleiter-Wafers (100) aus der zweiten Hauptfläche (102) desselben gebildet wird, und wobei der zweite Kavitätsteil (250) durch Ätzen des zweiten Halbleiter-Wafers (200) aus der zweiten Hauptfläche (202) desselben gebildet wird.

5. Verfahren nach einem der vorhergehenden Ansprüche, ferner umfassend, vor dem Bilden des ersten Kavitätsteils (150), das Bilden einer Bonding-Schicht (144) auf der zweiten Hauptfläche (102) des ersten Halbleiter-Wafers (100).

6. Verfahren nach Anspruch 5, ferner umfassend, vor dem Bilden des zweiten Kavitätsteils (250), das Bilden einer Bonding-Schicht (244) auf der zweiten Hauptfläche (202) des zweiten Halbleiter-Wafers (200).

7. Verfahren nach Anspruch 6, wobei jede der Bonding-Schichten (144, 244) eine dielektrische Schicht ist, und wobei das Bonden das Anordnen des ersten Halbleiter-Wafers (100) im Verhältnis zu dem zweiten Halbleiter-Wafer (200) umfasst, so dass die Bonding-Schicht (144) auf dem ersten Halbleiter-Wafer (100) an der Bonding-Schicht (244) auf dem zweiten Halbleiter-Wafer (200) anstößt.

8. Verfahren nach einem der vorhergehenden Ansprüche, ferner umfassend, nach dem Bilden der ersten Elektrodenstruktur (110) und vor dem Bilden des ersten Kavitätsteils (150), das Verdünnen des ersten Halbleiter-Wafers (100).

9. Verfahren nach einem der vorhergehenden Ansprüche, ferner umfassend:
nach dem Bilden der ersten Elektrodenstruktur (110) und vor dem Bilden des ersten Kavitätsteils (150), das Bonden des ersten Halbleiter-Wafers (100) mit einem ersten Träger-Wafer (140), wobei die erste Hauptfläche (101) des ersten Halbleiter-Wafers (100) dem Träger-Wafer (140) gegenübersteht, und
nach dem Bilden der zweiten Elektrodenstruktur (210) und vor dem Bilden des zweiten Kavitätsteils (250), das Bonden des zweiten Halbleiter-Wafers (200) mit einem zweiten Träger-Wafer (240), wobei die erste Hauptfläche (201) des zweiten Halbleiter-Wafers (200) dem zweiten Träger-Wafer (240) gegenübersteht.

10. Verfahren nach Anspruch 9, ferner umfassend, nach dem Bonden des ersten Halbleiter-Wafers (100) und des zweiten Halbleiter-Wafers (200), das Entfernen mindestens eines von dem ersten Träger-Wafer (140) und dem zweiten Träger-Wafer (240).

11. Verfahren nach einem der vorhergehenden Ansprüche, wobei das Verfahren ferner das Bilden eines Durchgangslochs (131) in der Isolierschicht (130) durch Ätzen umfasst, wobei das Durchgangsloch (131) einen Lichtaustritt der lonenkavität (300) bildet.

12. Verfahren nach Anspruch 11, wobei das Verfahren ferner das Bilden eines Durchgangslochs (231) in der Isolierschicht (230) durch Ätzen umfasst, wobei die Durchgangslöcher (131, 231) jeweils eine Lichteinlassöffnung der lonenkavität (300) und eine Lichtauslassöffnung der Ionenkavität (300) bilden.

13. Verfahren nach einem der Ansprüche 11 bis 12, wobei die erste Elektrodenstruktur (110) gebildet wird, um ein erstes Elektrodenpaar (111, 112) zu umfassen, und die zweite Elektrodenstruktur gebildet wird, um ein zweites Elektrodenpaar (211, 212) zu umfassen, und das Verfahren umfasst:
das Bilden des Durchgangslochs (131) in der Isolierschicht (130), die auf dem ersten Halbleiter-Wafer (100) in einer Position zwischen den Elektroden des ersten Paars (111, 112) gebildet wird, und das Bilden des Durchgangslochs (231) in der Isolierschicht (230), die auf dem zweiten Halbleiter-Wafer (200) in einer Position zwischen den Elektroden des zweiten Paars (211, 212) gebildet wird.

14. Verfahren nach einem der vorhergehenden Ansprüche, ferner umfassend:
Bilden auf der ersten Hauptfläche (101) des ersten Halbleiter-Wafers (100) einer dritten Elektrodenstruktur (402, 404), und
Bilden auf der ersten Hauptfläche (201) des zweiten Halbleiter-Wafers (200) einer vierten Elektrodenstruktur (502, 504),
wobei der erste Kavitätsteil (150) als ein erster Graben (160) in der zweiten Hauptfläche (102) des ersten Wafers (100) gebildet wird, wobei die erste Elektrodenstruktur (110) und die dritte Elektrodenstruktur (402, 404) entlang des ersten Grabens (160) angeordnet sind,
wobei der zweite Kavitätsteil (250) als ein zweiter Graben (260) in der zweiten Hauptfläche (202) des zweiten Wafers (200) gebildet wird, wobei die zweite Elektrodenstruktur (210) und die vierte Elektrodenstruktur (502, 504) entlang des zweiten Grabens (260) angeordnet sind, und
wobei der erste Graben (160) und der zweite Graben (260) beim Bonden des ersten Halbleiter-Wafers (100) und des zweiten Halbleiter-Wafers (200) aufeinander ausgerichtet werden, so dass eine gemeinsame Längskavität durch den ersten Graben (160) und den zweiten Graben (260) definiert wird.

## Revendications

1. Procédé de fabrication d'un piège à ions (10), le procédé comprenant :
la réalisation d'un premier traitement de damasquinage pour former une première structure d'électrodes (110) et une couche isolante (130) sur une première surface principale (101) d'une première tranche semi-conductrice (100), la première structure d'électrodes (110) étant noyée dans la couche isolante (130),
la réalisation d'un deuxième traitement de damasquinage pour former une deuxième structure d'électrodes (210) et une couche isolante (230) sur une première surface principale (201) d'une deuxième tranche semi-conductrice (200), la deuxième structure d'électrodes (210) étant noyée dans la couche isolante (230), et ensuite
la formation d'une première partie de cavité (150) s'étendant à travers la première tranche semi-conductrice (100) à partir d'une deuxième surface principale (102) de celle-ci vers la première structure d'électrodes (110),
la formation d'une deuxième partie de cavité (250) s'étendant à travers la deuxième tranche semi-conductrice (200) à partir d'une deuxième surface principale (202) de celle-ci vers la deuxième structure d'électrodes (210), et
la liaison entre-elles de la première tranche semi-conductrice (100) et la deuxième tranche semi-conductrice (200) avec la deuxième surface principale (102) de la première tranche semi-conductrice (100) tournée vers la deuxième surface principale (202) de la deuxième tranche semi-conductrice (200) et avec la première partie de cavité (150) et la deuxième partie de cavité (250) alignées pour définir ensemble une cavité ionique (300), dans lequel la première structure d'électrodes (110) et la deuxième structure d'électrodes (210) sont adjacentes sur des côtés opposés de la cavité ionique (300).

2. Procédé selon la revendication 1, dans lequel la première structure d'électrodes (110) est formée de manière à comprendre une première paire d'électrodes (111, 112), et la deuxième structure d'électrodes (210) est formée de manière à comprendre une deuxième paire d'électrodes (211, 212).

3. Procédé selon l'une quelconque des revendications précédentes, dans lequel chaque électrode de la première paire d'électrodes (111, 112) comprend une partie d'électrode inférieure (111a, 112a) respective formée dans une partie inférieure de la couche isolante (130), une partie d'électrode supérieure (111c, 112c) respective formée dans une partie supérieure de la couche isolante (130), et une partie de trou d'interconnexion d'électrodes (111b, 112b) respective s'étendant à travers la couche isolante (130) et interconnectant lesdites parties d'électrode supérieure et inférieure (111a, 111c, 112a, 112c) respectives, et
dans lequel lesdites parties d'électrode inférieure et supérieure (111a, 111c, 112a, 112c) respectives font saillie à partir de ladite partie de trou d'interconnexion d'électrodes (111b, 112b) respective dans un plan s'étendant le long de la première surface principale (101) de la première tranche (100).

4. Procédé selon l'une quelconque des revendications précédentes, dans lequel la première partie de cavité (150) est formée par gravure de la première tranche semi-conductrice (100) à partir de la deuxième surface principale (102) de celle-ci, et
dans lequel la deuxième partie de cavité (250) est formée par gravure de la deuxième tranche semi-conductrice (200) à partir de la deuxième surface principale (202) de celle-ci.

5. Procédé selon l'une quelconque des revendications précédentes, comprenant en outre, avant de former la première partie de cavité (150), la formation d'une couche de liaison (144) sur la deuxième surface principale (102) de la première tranche semi-conductrice (100).

6. Procédé selon la revendication 5, comprenant en outre, avant la formation de la deuxième partie de cavité (250), la formation d'une couche de liaison (244) sur la deuxième surface principale (202) de la deuxième tranche semi-conductrice (200).

7. Procédé selon la revendication 6, dans lequel chacune desdites couches de liaison (144, 244) est une couche diélectrique, et dans lequel ladite liaison comprend l'agencement de la première tranche semi-conductrice (100) par rapport à la deuxième tranche semi-conductrice (200) de sorte que la couche de liaison (144) sur la première tranche semi-conductrice (100) vient en butée contre la couche de liaison (244) sur la deuxième tranche semi-conductrice (200).

8. Procédé selon l'une quelconque des revendications précédentes, comprenant en outre, suite à la formation de la première structure d'électrodes (110) et avant la formation de la première partie de cavité (150), l'amincissement de la première tranche semi-conductrice (100).

9. Procédé selon l'une quelconque des revendications précédentes, comprenant en outre :
suite à la formation de la première structure d'électrodes (110) et avant la formation de la première partie de cavité (150), la liaison entre la première tranche semi-conductrice (100) et une première tranche de support (140) avec la première surface principale (101) de la première tranche semi-conductrice (100) tournée vers la tranche de support (140), et
suite à la formation de la deuxième structure d'électrodes (210) et avant la formation de la deuxième partie de cavité (250), la liaison entre la deuxième tranche semi-conductrice (200) et une deuxième tranche de support (240) avec la première surface principale (201) de la deuxième tranche semi-conductrice (200) tournée vers la deuxième tranche de support (240).

10. Procédé selon la revendication 9, comprenant en outre, suite à ladite liaison entre-elles de la première tranche semi-conductrice (100) et la deuxième tranche semi-conductrice (200), l'enlèvement d'au moins l'une parmi la première tranche de support (140) et la deuxième tranche de support (240).

11. Procédé selon l'une quelconque des revendications précédentes, le procédé comprenant en outre la formation d'un trou traversant (131) dans la couche isolante (130) par gravure, dans lequel ledit trou traversant (131) forme un orifice de passage de lumière de la cavité ionique (300).

12. Procédé selon la revendication 11, dans lequel le procédé comprend en outre la formation d'un trou traversant (231) dans la couche isolante (230) par gravure, dans lequel lesdits trous traversants (131, 231) forment respectivement une ouverture d'entrée de lumière de la cavité ionique (300) et une ouverture de sortie de lumière de la cavité ionique (300).

13. Procédé selon l'une quelconque des revendications 11-12, dans lequel la première structure d'électrodes (110) est formée de manière à comprendre une première paire d'électrodes (111, 112) et la deuxième structure d'électrodes est formée de manière à comprendre une deuxième paire d'électrodes (211, 212), et le procédé comprend : la formation dudit trou traversant (131) dans la couche isolante (130) formée sur la première tranche semi-conductrice (100) dans une position entre les électrodes de la première paire (111, 112), et la formation dudit trou traversant (231) dans la couche isolante (230) formée sur la deuxième tranche semi-conductrice (200) dans une position entre les électrodes de la deuxième paire (211, 212).

14. Procédé selon l'une quelconque des revendications précédentes, comprenant en outre :
la formation, sur la première surface principale (101) de la première tranche semi-conductrice (100), d'une troisième structure d'électrodes (402, 404), et
la formation, sur la première surface principale (201) de la deuxième tranche semi-conductrice (200), d'une quatrième structure d'électrodes (502, 504),
dans lequel la première partie de cavité (150) est formée en tant que première tranchée (160) dans la deuxième surface principale (102) de la première tranche (100), dans lequel la première structure d'électrodes (110) et la troisième structure d'électrodes (402, 404) sont agencées le long de la première tranchée (160),
dans lequel la deuxième partie de cavité (250) est formée en tant que deuxième tranchée (260) dans la deuxième surface principale (202) de la deuxième tranche (200), dans lequel la deuxième structure d'électrodes (210) et la quatrième structure d'électrodes (502, 504) sont agencées le long de la deuxième tranchée (260), et
dans lequel la première tranchée (160) et la deuxième tranchée (260),
lors de la liaison entre la première tranche semi-conductrice (100) et la deuxième tranche semi-conductrice (200), sont alignées l'une avec l'autre de sorte qu'une cavité longitudinale commune est définie par la première tranchée (160) et la deuxième tranchée (260).
